# EUROPEAN PATENT SPECIFICATION

(11) **EP 2 582 213 B1**
(45) Date of publication and mention of the grant of the patent: **20.01.2021**
(21) Application number: 11792519.8
(22) Date of filing: 09.06.2011
(51) Int. Cl.: H05K 1/02, H01L 23/473, H05K 3/46

(54) **FLOW CHANNEL MEMBER, HEAT EXCHANGER USING SAME, AND ELECTRONIC COMPONENT DEVICE**
FLUSSKANALELEMENT, WÄRMETAUSCHER DAMIT UND VORRICHTUNG MIT ELEKTRONISCHEN KOMPONENTEN
ELÉMENT DE CANAL D'ÉCOULEMENT, ÉCHANGEUR DE CHALEUR UTILISANT CELUI-CI ET DISPOSITIF DE COMPOSANT ÉLECTRONIQUE

(30) Priority: 09.06.2010 JP 2010132103
(43) Date of publication of application: 17.04.2013
(73) Proprietor: Kyocera Corporation, Kyoto-shi Kyoto 612-8501 (JP)
(72) Inventor: TSUBOKAWA,Kenji, Kyoto 612-8501 (JP); FUJIO, Kazuhiko, Kyoto 612-8501 (JP); MAEDA, Kenjiro, Kyoto 612-8501 (JP)
(74) Representative: Viering, Jentschura & Partner mbB Patent- und Rechtsanwälte
(86) International application number: PCT/JP2011/063250
(87) International publication number: WO 2011/155562

(56) References cited:
- EP-A1- 1 542 516
- EP-A2- 1 538 884
- WO-A1-2006/058494
- WO-A1-2006/118031
- DE-A1- 3 323 830
- JP-A- 3 296 646
- JP-A- H02 306 097
- JP-A- 2002 329 938
- JP-A- 2002 329 938
- JP-A- 2007 123 547
- JP-A- 2008 071 800
- JP-U- 56 026 959
- US-A1- 2007 227 697
- US-A1- 2009 020 274
- US-B1- 6 490 159
- US-B2- 7 311 137

## Description

### Technical Field

The present invention relates to a flow channel member, and a heat exchanger using the same and an electronic component device.

### Background Art

In recent years, accompanying high integration and an increase in speed of a semiconductor element that is mounted on an electronic component, an amount of heat generated from the semiconductor element increases. In addition, since the electronic component is used under a high-temperature environment, cooling of the electronic component is increasingly necessary.

A flow channel member disclosed in Patent Literature 1 is a circuit substrate that is formed by firing a plurality of laminated sheets, and a cooling medium flow channel, which has an approximately circular cross-section through which a cooling medium flows, is formed inside the flow channel member.

A flow channel member according to the preamble of claim 1 is known, e.g., from JP H02 306097 A. Further WO 2006/118031 A1 discloses an insulating circuit board that is provided with a wiring layer whereupon a power device is mounted on the surface, an insulating substrate bonded on a rear plane of the wiring layer, and a corrugated fin wherein a plurality of fins is formed in a wave-shape and top sections of the fins are bonded on the rear plane side of the insulating substrate.

### Citation List

### Patent Literature

Patent Literature 1: Japanese Unexamined Patent Publication JP-A 7-142822 (1995)

US2009/0020274A1 discloses a heat diffusing device in which the side walls of a sealed space are formed by laminated metallic plates which define between them grooves surrounding the space.

### Summary of Invention

### Technical Problem

However, during manufacturing the flow channel member disclosed in Patent Literature 1, a plurality of ceramic green sheets are punched into a desired shape using a die, are laminated, and are pressed to be joined to each other, and then the resultant joined member is fired to obtain a hollow flow channel member. However, Patent Literature 1 does not disclose or suggest forming a gap, which communicates with a flow channel, at a joined portion between a cover unit and a side wall unit that are parts forming the flow channel so as to increase a contact area between the flow channel and a fluid.

The invention has been made to solve the above-described problem, and an object thereof is to provide a flow channel member in which a volume of a flow channel is increased and heat exchange efficiency is improved, and a heat exchanger and an electronic component device that use the flow channel member.

### Solution to Problem

The present invention provides a flow channel member according to claim 1. Further advantageous embodiments of the flow channel member of the present invention are disclosed in dependent claims 2-5.

In addition, the present invention provides a heat exchanger according to claim 6.

In addition, the present invention provides an electronic component device according to claim 7.

### Advantageous Effects of Invention

According to the flow channel member of the invention, the flow channel member includes a cover unit, a side wall unit, and a bottom plate unit, a flow channel through which a fluid can flow is provided inside the flow channel member, and a gap which communicates with the flow channel is provided between the cover unit and the side wall unit. Therefore, when the flow channel member is used in a state where an object to be heat-exchanged is mounted on a cover unit side of the flow channel member, since the gap which communicates with the flow channel is located between the cover unit and the side wall unit, a volume of the flow channel through which a fluid flows increases, and thus heat exchange efficiency between the fluid and the object may be increased.

In addition, according to the heat exchanger of the invention, the heat exchanger includes the flow channel member of the invention and a metallic plate, on which an object to be heat-exchanged is mounted, disposed on an outer surface of the cover unit of the flow channel member, and thus a heat exchanger in which heat exchange efficiency is high may be provided.

In addition, according to the electronic component device of the invention, the electronic component device includes the heat exchanger of the invention and an electronic component mounted on the heat exchanger, and thus an electronic component device in which heat exchange efficiency is high may be provided.

### Brief Description of Drawings

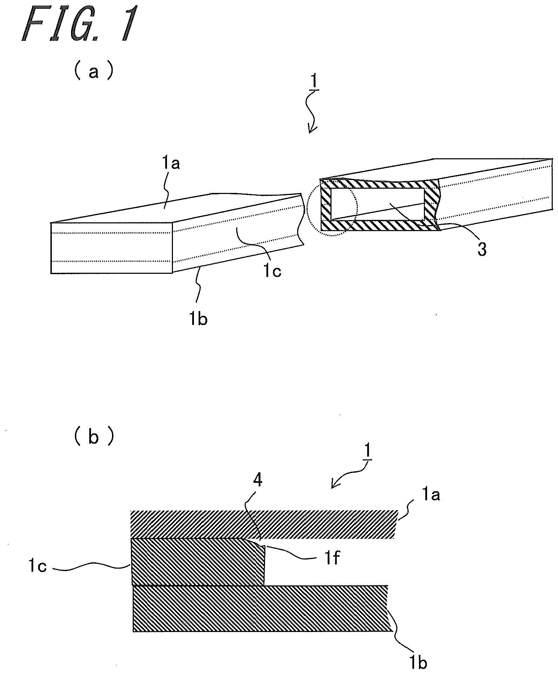

Fig. 1 is views illustrating an example of a flow channel of this embodiment, in which Fig. 1(a) is a perspective view illustrating a cross-section that is orthogonal to a longitudinal direction of a flow channel, and Fig. 1(b) is a partially enlarged view illustrating the inside of a circle surrounded by a broken line of Fig. 1(a) ;

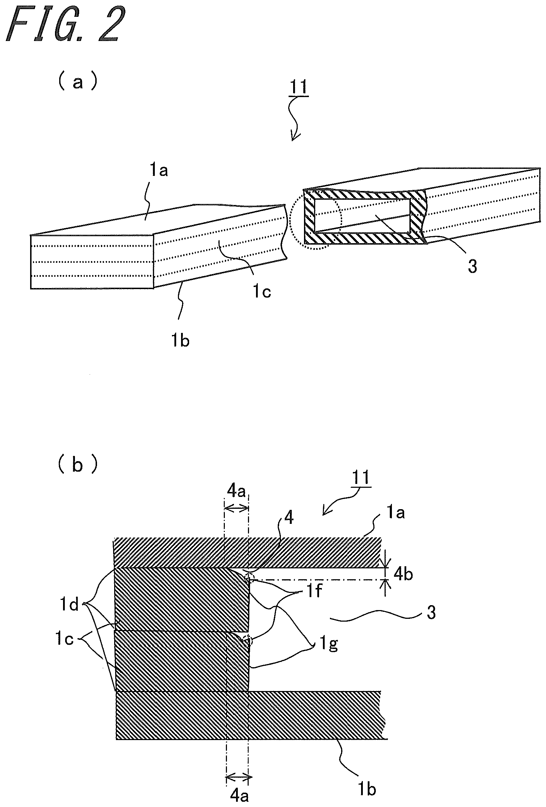

Fig. 2 is views illustrating another example of a flow channel member of this embodiment, in which Fig. 2(a) is a perspective view illustrating a cross-section that is orthogonal to a longitudinal direction of a flow channel, and Fig. 2(b) is a partially enlarged view illustrating the inside of a circle surrounded by a broken line of Fig. 2 (a) ;

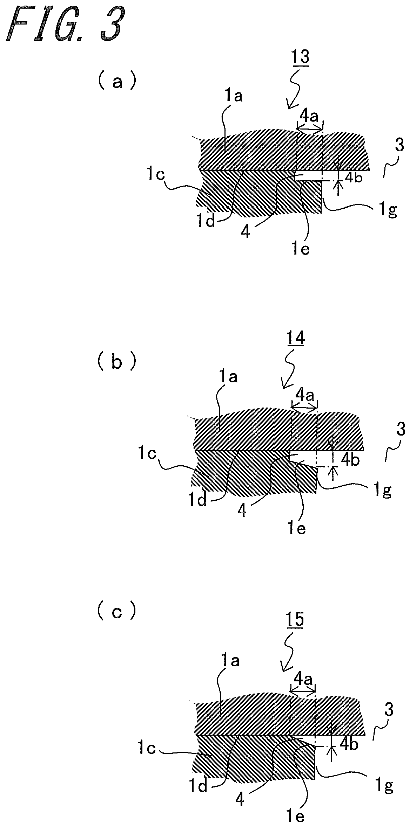

Fig. 3 is cross-sectional views illustrating an example of a gap in the flow channel member of this embodiment, in which Fig. 3(a) is a view illustrating a rectangular shape, Fig. 3(b) is a view illustrating a trapezoidal shape, and Fig. 3(c) is a view illustrating a shape in which the height in a vertical direction becomes lower toward a direction to the side wall;

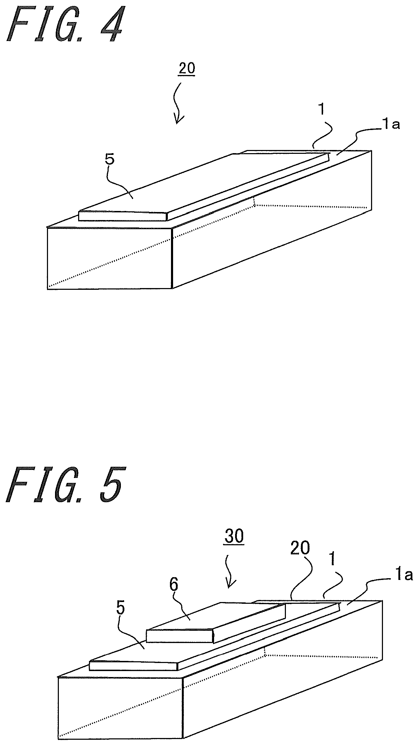

Fig. 4 is a perspective view illustrating an example of a heat exchanger in which a metallic plate is disposed on an outer surface of the cover unit of the flow channel member of this embodiment;
Fig. 5 is a perspective view illustrating an example of an electronic component device in which an electronic component is mounted on the metallic plate of the heat exchanger of this embodiment;

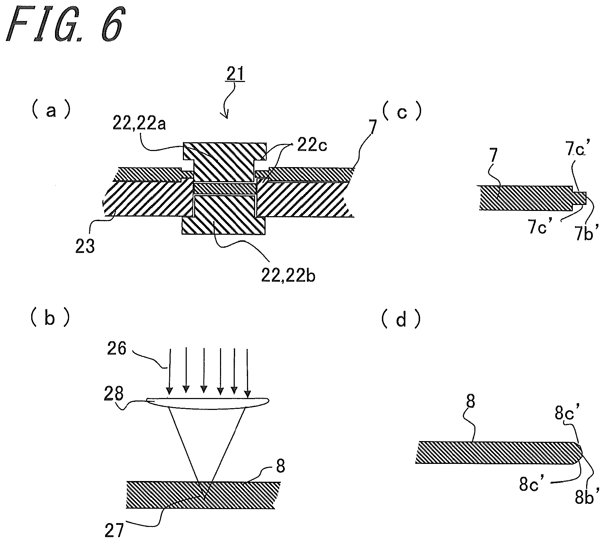

Fig. 6 is views illustrating an example of a method of processing the ceramic green sheet to form a penetration hole, which becomes a flow channel, in the ceramic green sheet that makes up the side wall unit of the flow channel member of this embodiment, in which Fig. 6(a) is a schematic cross-sectional view when using a die, Fig. 6(b) is a schematic cross-sectional view when using laser light, and Figs. 6(c) and 6(d) are partial cross-sectional views of a face orthogonal to a cut face of the ceramic green sheet when using the respective processing methods; and

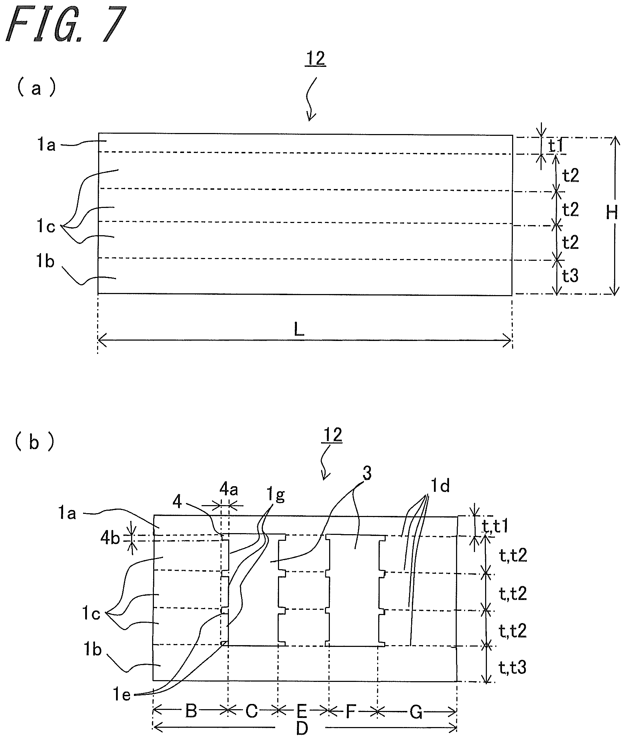

Fig. 7 is views illustrating a flow channel member of this embodiment, in which Fig. 7(a) is a side view and Fig. 7(b) is a cross-sectional view.

### Description of Embodiments

Hereinafter, an example of an embodiment of a flow channel member of the invention will be described.

Fig. 1 is views illustrating an example of a flow channel of this embodiment, in which Fig. 1(a) is a perspective view illustrating a cross-section that is orthogonal to a longitudinal direction of a flow channel, and Fig. 1(b) is a partially enlarged view illustrating the inside of a circle surrounded by a broken line of Fig. 1(a).

As shown in Figs. 1(a) and 1(b), the flow channel member 1 of this embodiment includes a cover unit 1a, a side wall unit 1c, and a bottom plate unit 1b. A flow channel 3, through which a fluid such as a gas and a liquid that cools an electronic component flows, is provided inside the flow channel member 1. A gap 4 which communicates with the flow channel 3 is provided between the cover unit 1a and the side wall unit 1c.

According to the flow channel member 1 of this embodiment, it is important that the flow channel member 1 includes the cover unit 1a, the side wall unit 1c, and the bottom plate unit 1b, the flow channel 3 through which a fluid flows is provided inside the flow channel member 1, and the gap 4 which communicates with the flow channel 3 is provided between the cover unit 1a and the side wall unit 1c.

According to the flow channel member 1 of this embodiment, since the gap 4 which communicates with the flow channel 3 is provided between the cover unit 1a and the side wall unit 1c that form the flow channel 3 through which a fluid flows, a volume of the flow channel increases compared to a case in which the gap 4 is not provided, and thus when the flow channel member 1 is used in a state where an object to be heat-exchanged is mounted on a cover unit 1a side of the flow channel member 1, heat exchange efficiency between the cover unit 1a and the fluid may be increased. In addition, during a process of manufacturing the flow channel member 1, when a plate-like body including the cover unit 1a and the side wall unit 1c is individually prepared, it is necessary to form a penetration hole that becomes the flow channel 3 in the plate-like body in advance. However, in a case of forming the penetration hole, not a few burrs may occur on an end face of the penetration hole. In the flow channel member 1 of this embodiment, since the gap 4 which communicates with the flow channel 3 is provided between the cover unit 1a and the side wall unit 1c, even when the flow channel member 1 having a flow channel through which a fluid flows is manufactured by laminating the cover unit 1a, the side wall unit 1c, and the bottom plate unit 1b, pressing these to be joined to each other, and firing the resultant joined member, a burr 1f enters the gap 4, and thus there is a little concern that the burr 1f is interposed at a joint portion 1d. Therefore, occurrence of joint failure may be reduced. As a result thereof, even when a fluid is made to flow through the flow channel member 1 at a high pressure, occurrence of breakage of the flow channel 3 from the inside thereof may be suppressed.

Fig. 2 is views illustrating another example of a flow channel member of this embodiment, in which Fig. 2(a) is a perspective view illustrating a cross-section that is orthogonal to a longitudinal direction of a flow channel, and Fig. 2(b) is a partially enlarged view illustrating the inside of a circle surrounded by a broken line of Fig. 2(a).

In a flow channel member 11, which is shown in Figs. 2(a) and 2(b) and illustrates another example of this embodiment, the side wall unit 1c is configured by laminating a plurality of sheets of plate-like bodies in which a penetration hole that becomes the flow channel 3 is formed. In addition, a gap 4 which communicates with the flow channel 3 is provided between the cover unit 1a and the side wall unit 1c (at the joint portion 1d), and a gap 4 which communicates with the flow channel 3 is provided between the respective plate-like bodies (at a joint portion 1d) of the side wall unit 1c.

In this flow channel member 11, for example, when it is necessary for the flow channel member 11 to have superior chemical resistance as a heat exchanger of a chemical solution, it is preferable that the cover unit 1a, the side wall unit 1c, and the bottom plate unit 1b are manufactured from ceramics, respectively. When the respective members are manufactured from ceramics, for example, the flow channel member 11 may be manufactured by firing a laminated body in which non-fired ceramic green sheets are laminated.

In addition, when forming the flow channel 3 through which a fluid flows, for example, a penetration hole that becomes an arbitrary flow channel 3 may be formed in advance in a plate-like body of a non-fired ceramic green sheet that becomes the side wall unit 1c. In addition, in the case of manufacturing the side wall unit by laminating a plurality of green sheets, a penetration hole corresponding to each plate-like body is formed. In addition, such a non-fired ceramic green sheet in which the penetration hole is formed and ceramic green sheets to cover the penetration hole from an upper side and a lower side thereof are prepared. Then, these ceramic green sheets are laminated, are pressed, and are fired to form the flow channel member 11.

However, when manufacturing the plate-like body that becomes the side wall unit 1c, it is difficult to avoid occurrence of a burr at an end face of the penetration hole. When these ceramic green sheets are laminated and are pressed, the burr that occurred at the end face of the penetration hole is interposed at a joint portion of the ceramic green sheets, and even when the laminated ceramic green sheets are pressed, a pressing force is focused on the burr interposed at the joint portion, and thus pressing irregularity occurs. Therefore, joint failure may occur. In the flow channel member 11 of this embodiment, since the gap 4 which communicates with the flow channel 3 is provided at the joint portion 1d, there is a little concern that the burr 1f, which occurs at the end surface 1g of the side wall unit 1c, is interposed at the joint portion 1d, and thus occurrence of joint failure is suppressed to be low. Therefore, even when a fluid is made to flow through the flow channel 3, since the joint failure is small, the occurrence of a problem such as cracking and breakage of the flow channel 3 may be suppressed.

In the above description, description was made with respect to an example in which the material of the flow channel member 1 is set to be ceramics, but even when the cover unit 1a is formed of ceramics and the side wall unit 1c is formed of another material such as an aluminum-based metal and a copper-based metal, the same effect may be obtained.

Fig. 3 is cross-sectional views illustrating an example of the gap in the flow channel member of this embodiment, in which Fig. 3(a) shows a view illustrating a rectangular shape, Fig. 3(b) shows a view illustrating a trapezoidal shape, and Fig. 3(c) shows a view illustrating a shape in which the height in a vertical direction becomes lower toward a direction to the side wall.

As shown in Figs. 3(a) and 3(b), when seen in a cross-sectional view in a direction orthogonal to a direction in which a fluid flows, flow channel members 13 and 14 have a rectangular gap 4 and a trapezoidal gap 4, which communicate with the flow channel 3, at the joint portion 1d between the cover unit 1a and the side wall unit 1c, respectively. The distance of each of the gaps 4 in a depth direction of the joint portion 1d is set to 4a (hereinafter, simply referred to as a "depth 4a"), and the maximum height of each of the gaps 4 in a direction in which the gap 4 vertically opens is set to 4b (hereinafter, simply referred to as a "maximum height 4b") .

In this manner, in a case where the gap 4 has a rectangular or trapezoidal shape, when the penetration hole, which becomes the flow channel 3, is formed in a ceramic green sheet during a process of forming a penetration hole to configure the flow channel 3, even when a burr occurs on an end face of the penetration hole, in a flow channel member that is obtained by laminating, pressing, and firing the ceramic green sheet at a predetermined temperature, since the gap 4, which opens toward the flow channel 3 side, is located at the joint portion 1d of the side wall unit 1c, and the gap 4 has a rectangular or trapezoidal shape having constant depth 4a and maximum height 4b, the burr enters the gap 4, and thus interposing of the burr at the joint portion 1d may be reduced. Therefore, occurrence of joint failure, cracking, and breakage of the flow channel may be suppressed between the cover unit 1a and the side wall unit 1c, even when the side wall unit 1c is a laminated body of a plurality of plate-like bodies.

In addition, with respect to a flow channel member 15 shown in Fig. 3(c), when seen in a cross-sectional view in a direction orthogonal to a direction in which a fluid flows, at a joint portion 1d between the cover unit 1a and the side wall unit 1c, where the joint portion 1d communicates with the flow channel 3, between a plurality of sheets of laminated plate-like bodies that make up the side wall unit 1c, the gap 4 is formed in a shape in which a height in a direction where the gap 4 vertically opens becomes lower toward a direction in which the gap 4 extends to the side wall unit 1c side (hereinafter, referred to as a triangular shape).

As described above, in a case where a cross-sectional shape of the gap 4 is set to a triangular shape, there is a method in which in a process of forming a penetration hole to configure the flow channel 3, the penetration hole that becomes the flow channel 3 is formed in a ceramic green sheet, for example, by a die, and a portion, which is chamfered while punching the ceramic green sheet to form the penetration hole, is pressed using a protruding punch to form a chamfered portion. According to this method, a volume amount of the chamfered portion is compressed into a portion that is immediately close to the chamfered portion, and thus the density of the ceramic green sheet is increased, and a part of the volume amount is trapped in a clearance between the punch and a stopper of the die, and may be present as a burr on an end face of the penetration hole.

However, compared to a chamfer having a rectangular shape or a trapezoidal shape, in the case of the triangular shape, the compressed volume is small and thus the burr that occurs at the end face of the penetration hole is apt to be small. Therefore, even when the ceramic green sheets are joined by laminating and pressing these sheets, interposing of the burr 1f at the joint portion 1d may be reduced, and thus occurrence of joint failure between the cover unit 1a and the side wall unit 1c, cracking, and breakage of the flow channel may be suppressed. In addition, since the gap 4 has a triangular shape, a contact area between a fluid and the flow channel member 1 increases, and thus improvement in heat exchange efficiency is realized. In addition, here, the triangular shape of the gap 4 may be an approximately triangular shape including shapes such as a wedge shape and a fish hook shape.

In addition, when seen in a cross-sectional view in a direction orthogonal to a direction in which the fluid flows with respect to the flow channel member of this embodiment, it is preferable that a relationship a > b is satisfied, wherein "a" denotes the depth in a direction in which the gap extends to the side wall unit side and "b" denotes a maximum height in a direction in which the gap vertically opens.

In the flow channel members shown in Fig. 1(b), Fig. 2(b), Fig. 3(a) and Fig. 3(b), the gap 4, which communicates with the flow channel 3 and has the depth 4a and the maximum height 4b, is located at the flow channel 3 side end surface 1g of the joint portion 1d between the cover unit 1a and the side wall unit 1c. However, in a process of forming the penetration hole to configure the flow channel 3, in a case where an end face of the penetration hole of the ceramic green sheet is chamfered, when the maximum height 4b of the gap 4 in the flow channel member 1 is made to be large, the height of the burr 1f that occurs at the end surface 1c also tends to be large. For example, when the gap is formed to have a large height by punching the ceramic green sheet to form the penetration hole using a die processing, a high density of a volume fraction of the chamfered portion may be focused on the vicinity of the end surface of the ceramic green sheet, and thus a part of the ceramic green sheet is trapped in a clearance between the punch and the stopper of the die, and the height of the burr that occurs increases. Therefore, from the viewpoint that there is a large concern that the burr 1f may be interposed at the joint portion 1d during lamination of the ceramic green sheets, it is preferable that a relationship a > b is satisfied, wherein "a" denotes the depth 4a of the gap 4 and "b" denotes a maximum height 4b in a direction in which the gap vertically opens.

According to this configuration, even when the burr 1f occurs, the burr 1f enters the gap 4, and interposing of the burr 1f at the joint portion 1d is reduced. Therefore, occurrence of joint failure, cracking, and breakage of the flow channel 3 may be suppressed. In addition, since the depth 4a is deeper than the maximum height 4b of the gap 4, the fluid that enters the gap 4 is apt to remain therein (a swirling flow occurs in the gap 4 due to flowing along a surface), and thus heat exchange efficiency between the fluid and the flow channel member 1 is improved.

In addition, in the flow channel member according to this embodiment, it is preferable that the depth of the gap is 0.03 or more and 0.08 mm or less.

When the depth 4a of gap 4 of the flow channel member 1 is 0.03 mm or more, it is possible to reduce a concern that the burr 1f of the end surface 1g, which occurs during a process of forming the penetrating hole to configure the flow channel 3, reaches the joint portion 1d and enters therein, and thus occurrence of joint failure may be further reduced. In addition, when the depth 4a is made to be long, a surface area of the flow channel 3 may increase, and thus heat exchange efficiency between the fluid and the flow channel member 1 is improved. In addition, when the depth 4a of the gap 4 is 0.08 m or less, in the process of forming the penetration hole to configure the flow channel 3, when a plurality of sheets of the ceramic green sheets in which the penetration hole that becomes the flow channel 3 is formed are laminated and are pressed, since the pressing force sufficiently propagates to the joint portion 1d, occurrence of the joint failure may be suppressed. In addition, even when a fluid is supplied at a high pressure to the flow channel member 1 obtained after being fired, cracking starting from the gap 4 and occurrence of breakage of the flow channel 3 may be suppressed.

As described above, in the flow channel member 1 of this embodiment, separation at the joint portion 1d between the cover unit 1a and the side wall unit 1c or occurrence of cracking is less, and even when the fluid is made to flow at a high pressure, occurrence of breakage from the inside of the flow channel 3 may be suppressed. In addition, since heat exchange efficiency is high, the flow channel member 1 may be used as a flow channel member that cools a semiconductor device or a semiconductor manufacturing apparatus, as a heat exchanging flow channel member of the semiconductor manufacturing apparatus in which heating and warming are repeated, and as a heat exchanger of a chemical fluid or a flow channel member for inkjet printers.

Fig. 4 is a perspective view illustrating an example of a heat exchanger in which a metallic plate is disposed on an outer surface of the cover unit of the flow channel member of this embodiment.

A heat exchanger 20 of this embodiment that is shown in Fig. 4 is provided with a metallic plate 5 that is joined on an outer surface of the cover unit 1a of the flow channel member 1 of this embodiment, inside which flow channel member the flow channel 3 through which a fluid flows is provided. In this manner, in a case where the metallic plate 5 is joined on the outer surface of the cover unit 1a, when an object to be heat-exchanged is mounted on the metallic plate 5, heat exchange with a fluid may be easily performed.

Fig. 5 is a perspective view illustrating an example of an electronic component device 30 in which an electronic component 6 is mounted on the metallic plate 5 of the heat exchanger 20 of this embodiment. According to this, when a fluid as a cooling medium is made to flow through the flow channel of the flow channel member 1, the electronic component 6 may be effectively cooled. Therefore, the electronic component device 30 in which occurrence of breakage of the flow channel is less, and heat exchange efficiency is high may be provided.

The electronic component device 30 is useful as a device dissipating high-temperature heat during operation, and examples of the electronic component device 30 include a semiconductor module such as a PCU, a semiconductor device of a high output LED headlight, a direct current high voltage power supply device, and a switching device.

Hereinafter, an example of a method of manufacturing the flow channel member 1 of this embodiment will be described.

The flow channel member 1 may be manufactured from a metal such as an aluminum-based metal and a copper-based metal, or a ceramic material, but in a case of manufacturing the flow channel from the ceramic material to enhance for example chemical resistance, alumina, zirconia, silicon nitride, silicon carbide, aluminum nitride, and a composite material thereof may be used as a ceramic material. Among these, alumina is preferable when considering an insulation property, a material cost, or the like. In addition, since a material, which contains silicon oxide or the like and in which a content of alumina is 94 to 97% by mass, is sintered at a relatively low temperature, this material is particularly preferable when considering a firing cost.

Hereinafter, description will be made in detail with respect to a case in which the flow channel member 1 is manufactured from alumina.

First, an aluminum oxide (Al₂O₃) powder having an average particle size of approximately 1.4 to 1.8 µm, and at least one kind of powders of silicon oxide (SiO₂), calcium oxide (CaO), and magnesium oxide (MgO) are prepared. Then, weighing is performed in such a manner that, for example, in a mixing ratio of the powders, aluminum oxide becomes 96.4% by mass, silicon oxide becomes 2.3% by mass, calcium oxide becomes 0.3% by mass, and magnesium oxide becomes 1.0% by mass, and then these powders are mixed to obtain a mixed powder. Then, this mixed powder is put into a rotary mill together with a binder formed of polyethylene glycol, and is mixed using alumina balls with high purity. Here, an addition amount of the binder is set to approximately 4 to 8% by mass on the basis of 100% by mass of the mixed powder. In addition, when the addition amount of the binder is within a range of approximately 4 to 8% by mass on the basis of 100% by mass of the mixed powder, the strength or flexibility of a molded body is superior, and a problem in which degreasing of the binder for molding becomes insufficient during firing the molded body may be suppressed.

Next, a binder such as polyvinyl alcohol, polyethylene glycol, an acrylic resin, and a butyal resin is added to the resultant mixed material in an amount of approximately 4 to 8% by mass on the basis of 100% by mass of the mixed powder, and the binder and the mixed material are mixed to obtain a slurry. Here, when the addition amount of the binder is set to approximately 4 to 8% by mass on the basis of 100% by mass of the mixed powder, the strength or flexibility of a molded body is superior, and a problem in which degreasing of the binder for molding becomes insufficient during firing the molded body may be suppressed.

Next, a ceramic green sheet is formed using this slurry by a doctor blade method or a roll compaction molding method that is a general molding method of ceramics, and the ceramic green sheet is punched to have a product shape by a die, whereby a ceramic green sheet is manufactured. As respective ceramic green sheets that are laminated, ceramic green sheets of the same lot are preferably used so as to reduce occurrence of deformation, bending, or cracking due to a difference in shrinkage while firing the laminated ceramic green sheets.

Fig. 6 is views illustrating an example of a method of processing the ceramic green sheet to form a penetration hole, which becomes a flow channel, in the ceramic green sheet that makes up the side wall unit of the flow channel member of this embodiment, in which Fig. 6(a) is a schematic cross-sectional view when using a die, Fig. 6(b) is a schematic cross-sectional view when using laser light, and Figs. 6(c) and 6(d) are partial cross-sectional views of a face orthogonal to a cut face of the ceramic green sheet when using the respective processing methods.

As shown in Fig. 6(a), a ceramic green sheet 7 is punched by a die 21 to form a rectangular chamfer 7c' in an end surface 7b' of the punched ceramic green sheet 7 as shown in Fig. 6(c). Particularly, an upper punch 22a and a lower punch 21c, which come into contact with the ceramic green sheet 7, are provided with convex portions 22c at both ends of contact surfaces, respectively. Therefore, when the ceramic green sheet 7 is punched by engagement between the upper and lower punches 22 while the ceramic green sheet 7 is interposed between the convex portions 22c, the rectangular chamfer 7c' may be formed in the end surface 7b' of the ceramic green sheet 7. In addition, when the chamfer 7c' is set to a trapezoidal shape, a C-face, or an R-face, the chamfer 7c' of this shape may be formed with the same method by changing a shape of the convex portion 22c of the punch 22. In addition, when the die 21 in which the lower punch 21c is not provided with the convex portion 22c is used, the rectangular chamfer 7c' may be formed in the end surface 7b' only on the upper punch 22a side of the ceramic green sheet 7.

In Fig. 6(b), a chamfer 8c' may be formed in an end surface 8b' of a ceramic green sheet 8 shown in Fig. 6(d) by performing laser processing with respect to the ceramic green sheet. Particularly, the ceramic green sheet 7 is irradiated with laser light 26 through a condensing lens 28. When a spot 27 is adjusted to be located at an approximately central portion in the thickness direction of the ceramic green sheet 8, the chamfer 8c' may be formed at vertical sides of the end surface 8b' of the ceramic green sheet 8.

In addition, in a case of laser-processing the ceramic green sheet, as a laser light source, CO₂ laser, YAG laser, excimer laser, or the like may be used. For example, in the case of CO₂ laser, an oscillation frequency of the laser light 26 is set to approximately 2,000 Hz, a pulse duty is set to 70 to 80% (a ratio of a signal-on time), and a moving speed of the laser light 26 on the ceramic green sheet 8 is set to 8 to 10 m/minute, whereby a cutting processing into a desired shape may be performed.

In addition, in a case of forming the chamfer 8c' only in one side of the vertical sides of the end surface 8b' of the ceramic green sheet 8, the focal point of the spot 27 of the laser light 26 may be adjusted onto any surface of upper and lower surfaces of the ceramic green sheet 8.

The plurality of ceramic green sheets 7 or 8 manufactured as described above are laminated to form a desired flow channel 3'. In this case, the same binder as that used when manufacturing the ceramic green sheet is applied to joining surfaces of the respective ceramic green sheets 7 or 8 as an adhesion liquid. After the ceramic green sheets 7 or 8 are laminated, a pressure of approximately 0.5 MPa is applied to the laminated ceramic green sheets using a plate-like pressing tool, and the laminated ceramic green sheets are dried at a normal temperature of approximately 50 to 70°C for approximately 10 to 15 hours.

Next, the laminated ceramic green sheets that make up the flow channel member 1 are fired, for example, in a publicly-known continuous tunnel furnace of a pusher type or a roller type. A firing temperature becomes different depending on each material, but in a material in which an alumina content is 94 to 97% by mass, the laminated ceramic green sheets may be fired under an oxidation atmosphere in which the maximum temperature is approximately 1500 to 1650°C.

Particularly, as shown in Fig. 5, in a case where a substrate, on which an electronic component 6 emitting high-temperature heat is mounted, is mounted on the cover unit 1a of the flow channel member 1, it is preferable that the thickness of the cover unit 1a that seals the penetration hole to form the flow channel is made to be thin as possible to improve heat exchange efficiency, and in a case of a material in which the alumina content is 94 to 97% by mass, it is preferable that the thickness is set to approximately 0.3 to 0.5 mm.

In this manner, the flow channel member 1 is manufactured, and the electronic component 6 such as an LSI and an LED is mounted on the flow channel member 1 through a metallic plate 5. When a gas or liquid cooling medium is made to flow through the flow channel of the flow channel member 1, the electronic component 6 may be cooled.

In addition, the flow channel member 1 of this embodiment may be used for various uses such as a cooling use and a warming use.

A flow channel member 12 shown in Fig. 7(a) of this embodiment has the total length of "L", the height of "H", and the width of "D", wherein one sheet of the cover unit 1a having the thickness of t1, three sheets of side wall units 1c having the thickness of t2, and one sheet of the bottom plate unit 1b having the thickness of t3 are laminated, and two rectangular flow channels 3 are formed inside the flow channel member 12. In addition, as shown in Fig. 7(b), a chamfer 1e that becomes a gap 4 is formed in an end surface 1g of each of the side wall units 1c that form the flow channel 3, and a gap 4, which opens toward the flow channel 3 side and has the depth 4a and the maximum height 4b, is formed at a joint portion 1d between the cover unit 1a and one of the side wall units 1c, and at a joint portion 1d between one of the side wall units 1c and the bottom plate unit 1b. In addition, the distances from the outside of the flow channel member 12 to the flow channel 3 are indicated by "B" and "G", respectively, the width of the flow channel 3 is indicated by "C" and "F", respectively, and the distance between adjacent flow channels 3 is indicated by "E".

Hereinafter, examples of the invention will be described in detail, but the invention is not limited to these examples.

### Example 1

An aluminum oxide (Al₂O₃) powder having an average particle size of approximately 1.6 µm, a silicon oxide (SiO₂) powder, a calcium oxide (CaO) powder, and a magnesium oxide (MgO) powder are prepared.

As mixing ratios of the respective powders, 96.4% by mass of aluminum oxide, 2.3% by mass of silicon oxide, 0.3% by mass of calcium oxide, and 1.0% by mass of magnesium oxide are weighed, and these powders are mixed to obtain a mixed powder. The mixed powder is put into a rotary mill together with a binder that is formed of 6% by mass of polyethylene glycol on the basis of 100% by mass of the mixed powder, and the mixed powder and the binder are mixed with alumina ball with high purity.

Next, 4% by mass of a binder such as acrylic resin on the basis of 100% by mass of the mixed powder is added to the resultant mixture, and this binder and the resultant mixture are mixed to obtain a slurry.

Next, ceramic green sheets are prepared using the obtained slurry by a publicly-known doctor blade method. In addition, individual ceramic green sheets are prepared using a die to realize a product shape when the ceramic green sheets are laminated.

In this example, samples having the same shape as the flow channel member 12 shown in Fig. 7(a) were prepared. In addition, the dimensions of the flow channel member 12 were set as follows. That is, the total length "L" was set to 200 mm, the total height "H" was set to 4.5 mm, the total width "D" was set to 12 mm, the thickness t1 of the cover unit 1a was set to 0.5 mm, the thicknesses t2 and t3 of the side wall unit 1c and the bottom plate unit 1b were set to 1.0 mm, respectively. In addition, the distances "B" and "G" from the outside of the flow channel member 12 shown in Fig. 7(b) to the flow channel 3 were set to 3 mm, respectively, the widths "C" and "F" of the flow channel 3 were set to 2 mm, respectively, and the distance "E" between adjacent flow channels 3 was set to 2 mm.

In addition, as shown in Table 1, 50 samples not having the depth 4a of the gap 4 shown in Fig. 7(b) (a sample in which the depth 4a is substantially 0.005 mm or less is regarded as a sample not having the depth 4a), 50 samples in which the depth 4a is 0.08 mm, 50 samples not having the maximum height 4b (a sample in which the maximum height 4b is substantially 0.005 mm or less is regarded as a sample not having the maximum height 4b), and 50 samples in which the maximum height 4b is 0.06 mm were prepared, respectively, and these samples belong to Sample Nos.1 and 24.

In addition, so as to confirm heat exchange efficiency of the flow channel member 12, a fluid supply port made of alumina was brazed to one side surface of the flow channel member 12 , and a fluid discharge port made of alumina was brazed to the other side surface of the flow channel member 12 which is opposite to the supply port.

In addition, flow channel members 12 in which the cover unit 1a was formed of ceramics, and the side wall unit 1c and the bottom plate unit 1b were formed of a metal were prepared.

The respective dimensions were the same as Sample Nos. 1 and 24, and the ceramics in the cover unit 1a were the same as Sample Nos. 1 and 24. As the metal used in the side wall unit 1c and the bottom plate unit 1b, aluminum having purity of 99.7% was used, and samples not having the gap 4 belong to Sample No. 101 and samples having the gap 4 belong to Sample No. 102.

In addition, in a method of forming respective penetration holes that have a dimension t2 and make up the flow channel members 12 of Sample Nos. 1 and 24, ceramic green sheets were shaped using the die 21 shown in Fig. 6(a). In this method, a rectangular chamfer was formed in an end surface of each of the ceramic green sheets so as to have the gap 4 shown in Fig. 7(b), whereby three ceramic green sheets having the exterior dimensions of the above-described flow channel members 12 were prepared.

Next, as an adhesion liquid during laminating, pressing, and adjoining the prepared ceramic green sheets, the same binder as when preparing the ceramic green sheets was used (hereinafter, not shown), in a method of applying the binder serving as the adhesion liquid, a stainless steel screen of 400 mesh that has the thickness of 0.02 mm was used, and the adhesion liquid was applied to an entire surface of each of the ceramic green sheets to be laminated by a rubber squeegee.

Next, five ceramic green sheets to which the adhesion liquid was applied were laminated, and the laminated ceramic green sheets were interposed between flat plates and were pressed at approximately 0.5 MPa.

At this time, Prescale (type name: LLLW for an ultra-low pressure of 0.2 to 0.6 MPa, manufactured by Fujifilm Corporation) (hereinafter, not shown) was inserted into a lower end of the ceramic green sheets so as to observe a pressure propagation state, and it was confirmed whether or not the entire surface of the laminated ceramic green sheets were uniformly pressed. At this time, when the entire surface of the ceramic green sheets were uniformly pressed, spots other than a flow channel pattern were colored in a red color, but in a case where the spots other than the flow channel pattern were not colored, pressing was performed again or the corresponding sample was excluded at that time.

Next, the flow channel members 12 as molded bodies having a product shape were fired in a pusher-type tunnel kiln in which the maximum temperature was set to 1600°C, thereby obtaining flow channel members of Sample Nos. 1 and 24 shown in Table 1, in which the gap 4 had a triangular shape. In addition, with respect to parts of the flow channel members 12, parts of non-fired products thereof were stored as samples to confirm a joint portion state.

In addition, in regard to a method of preparing Sample Nos. 101 and 102 in which the cover unit 1a was formed of alumina ceramics, and the side wall unit 1c and the bottom plate unit 1b were formed of an aluminum metal, the cover unit 1a was prepared by the same method as Sample Nos. 1 and 24, and the cover unit 1a that was fired in advance was prepared.

In addition, in regard to the side wall unit 1c and the bottom plate unit 1b, a unit in which the side wall unit 1c and the bottom plate unit 1b were integrally formed was prepared by a publicly-known hot extrusion molding method.

Next, the flow channel member 12 was prepared by joining the obtained cover unit 1a and the side wall unit 1c by brazing. In addition, in the brazing, a brazing material made of Al-Si was applied using a screen printing method, and a heat treatment was performed at a temperature of approximately 590°C in a pressed state at approximately 0.15 MPa.

Next, the fluid supply port and the fluid discharge port were prepared in the same manner as the Sample Nos. 1 and 24.

An ultrasonic testing was performed with respect to Sample No. 1 and 24 of the flow channel members 12 obtained as described above.

The ultrasonic testing was performed to confirm whether or not interlayer separation, which may be regarded as joint failure, is located at the joint portion 1d between the cover unit 1a and the side wall unit 1c that form the flow channel 3 inside the flow channel member 12 after being fired.

The ultrasonic testing was performed by using mi-scopehyper (type name, manufactured by Hitachi Kenki FineTech Co., Ltd.). The ultrasonic testing was performed on the entire surface of the flow channel member, in which with respect to the lamination thickness t of 4.5 mm of the cover unit 1a and the side wall unit 1c of the flow channel member 1, an ultrasonic probe (type name: 50P6F15) with a frequency of 50 MHz was used with respect to from the first layer to the second layer in a vertical direction, and an ultrasonic probe (type name: PT-3-25-17) with a frequency of 25 MHz was used with respect to the third layer that is an intermediate layer of the laminated layers. In addition, an image of the ultrasonic testing with respect to each of the first and second layers, the third layer, and the fourth and fifth layers of the cover unit 1a, the side wall unit 1c, and the bottom plate unit 1b that were laminated was observed. Here, the ultrasonic probe that was used is used in a distinguishable manner depending on the lamination thickness t of the ceramic sheets, and in a case where the thickness t becomes large, an ultrasonic probe with a further low frequency may be used.

In the ultrasonic testing, in a case where a vacancy is present, a white image is obtained, and in a case where a vacancy is absent, a black image is obtained. Therefore, in a case where a white portion is present at a position deviated from an original flow channel pattern, interlayer separation due to joint failure occurs.

An evaluation of the ultrasonic testing was performed by comparing a depth 4a of the gap 4 of each of the samples and a depth 4a of the gap that was obtained by the ultrasonic testing. In a case where a maximum difference between the depth 4a of the original gap 4 and the depth 4a of the gap 4 of the image obtained by the ultrasonic testing was within a range of ±10%, the corresponding sample was determined as a good product, and in a case where the maximum difference exceeded +10%, the corresponding sample was determined as a bad product. In addition, a sample in which the depth 4a is 0.005 mm or less is regarded as a sample that substantially does not have the gap 4. In addition, when a percentage of defective flow channel members 1 of the respective 50 samples was 0%, the evaluation was rated as "Very good", when the defective percentage was 2% or less, the evaluation was rated as "Good", and when the defective percentage exceeded 2%, the evaluation was rated as "Bad".

In addition, so as to clarify a cause of the joint failure, observation of whether or not a cause leading to the joint failure was present was performed with respect to the same non-fired flow channel members 12 as the respective samples using a magnifying lens (10 magnifications) while separating the joint portion 1d of each of the 50 samples with hands.

In addition, a degree of effect on heat exchange efficiency from a mounting surface on which an object to be heat-exchanged was mounted, due to the presence of the gap 4 communicating with the flow channel 3 at the joint portion 1d between the cover unit 1a and the side wall unit 1c of the flow channel member 12, was confirmed.

In the test method, a heater and a thermocouple were attached to the outer surface of the cover unit 1a of each of the above-described samples. In addition, a position at which the thermocouple was attached was heated to reach a temperature of 50°C.

Next, as a fluid, water with a water temperature of 18°C was supplied to the flow channel member 12 at approximately 0.3 MPa.

In this state, a surface temperature of the outer surface of the cover unit 1a was measured after the passage of 30 minutes, and an average temperature variation amount at each of the samples was confirmed.

The obtained results are shown in Table 1.

**[Table 1]**

| Sample No. | Material | Gap at joint portion between cover unit and side wall unit of flow channel | | | | Rate of occurrence of joint failure | Evaluation | Cause of joint failure | Temperature variation amount of cover unit on surface side after passage of 30 minutes |
|---|---|---|---|---|---|---|---|---|---|
| | | Present or absent | Shape | Depth | Maximum height | | | | |
| | | | | (mm) | (mm) | (%) | | | (°C) |
| 1 | All units are formed of ceramics | Absent | - | - | - | 8 | Bad | Burr | 18 |
| 24 | All units are formed of ceramics | Present | Triangular | 0.08 | 0.06 | 0 | Very good | - | 20 |
| 101 | Cover unit is formed of ceramics, and side wall unit and bottom plate unit are formed of aluminum | Absent | - | - | - | 0 | Very good | - | 26 |
| 102 | Cover unit is formed of ceramics, and side wall unit and bottom plate unit are formed of aluminum | Present | Triangular | 0.08 | 0.06 | 0 | Very good | - | 28 |

As can be seen from the results shown in Table 1, in Sample No. 1 in which the cover unit 1a and the side wall unit 1c were formed of ceramics, a rate of occurrence of joint failure was 8%, and an evaluation was bad. In addition, in the examination of the stored non-fired samples, it was confirmed that a burr, which occurred during shaping the ceramic green sheets by the die 21, was attached to the joint portion of the laminated ceramic green sheets, and due to this burr, the joining of the ceramic green sheets was not performed in a sufficient manner.

In addition, in Sample No. 24 with the same ceramics as Sample No. 1, the rate of occurrence of the joint failure was 0%, and the evaluation was very good.

This is considered because the depth 4a of the gap 4 was 0.08 mm, and the maximum height 4b was 0.06 mm, and thus even when the burr 1f occurred on the end surface 1g, the burr 1f did not enter the joint portion 1d between the cover unit 1a and the side wall unit 1c, and as a result thereof, the joint failure was prevented from occurring. Furthermore, the joint portion of the non-fired samples was confirmed, but occurrence of the joint failure due to trapping of the burr in the flow channel side end surface of the ceramic green sheet to the joint portion of the ceramic green sheet was not found.

In addition, in the Sample Nos. 101 and 102 in which the cover unit 1a was formed of alumina ceramics, and the side wall unit 1c and the bottom plate unit 1b were integrally molded from aluminum, and these units were jointed by brazing, regardless of the presence of the gap 4 communicating with the flow channel 3 at the joint portion 1d between the cover unit 1a and the side wall unit 1c, the joint failure did not occur. This is considered as follows. In regard to Sample Nos. 1 and 24, all of them were laminated as soft green molded bodies, were pressed, and were fired to be joined, and thus in the vicinity of the flow channel 3, propagation of a pressing force to an intermediate layer that becomes the side wall unit 1c greatly depends on whether or not the burr is present. Conversely, in Sample Nos. 101 and 102, since sintered bodies are joined to each other, when the burr is present at the end surface or the like, this burr may be removed by polishing or the like, and due to the thickness of a brazing material or the like, flatness is provided and the burr may be absorbed therein. In addition, since hard bodies are joined to each other, the propagation of the pressing force to the vicinity of the flow channel is less effected.

In addition, from results of heating and cooling tests of the flow channel member 12, it could be seen that even when the gap 4 was slightly present, the heat exchange efficiency was improved. Specifically, in a case where the cover unit 1a, the side wall unit 1c, and the bottom plate unit 1b were formed of ceramics, a temperature variation amount of Sample No. 1, in which the gap 4 communicating with flow channel 3 was absent at the joint portion 1d between the cover unit 1a and the side wall unit 1c, was 18°C. Conversely, the temperature variation amount of Sample No. 24 in which the gap 4 was present was 20°C.

In addition, similarly, in regard to Sample Nos. 101 and 102 in which the cover unit 1a was formed of ceramics, and the side wall unit 1c and the bottom plate unit 1b were formed of a metal, in Sample No. 101 in which the gap 4 was absent, the temperature variation amount was 26°C. Conversely, in Sample No. 102 in which the gap 4 was present, the temperature variation amount was 28°C. From these results, it can be seen that the heat exchange efficiency is improved when the gap 4 is present.

From the above-described results, it can be seen that when the gap 4 communicating with the flow channel 3 is present at the joint portion 1d between the cover unit 1a and the side wall unit 1c of the flow channel member 12, a thermal contact area between the flow channel 3 and a fluid increases, and according to this increase, the efficiency of heat exchange with the outer surface of cover unit 1a is improved.

In addition, in a case where the ceramic green sheets are laminated and the flow channel is formed inside the laminated ceramic green sheets, since the gap 4, which communicates with the flow channel 3 and is formed in the joint portion 1d between the cover unit 1a and the side wall unit 1c, absorbs the burr, which occurs during forming the penetration hole that becomes the flow channel 3 of the ceramic green sheet, in the gap 4, and thus the burr is not interposed at the joint portion 1d. As a result, it can be seen that occurrence of the joint failure may be suppressed.

Here, it is described that the material of the flow channel member may be any one of the ceramics and the metal. However, in a case where the flow channel is bent, it is difficult to integrally mold the flow channel member by extrusion molding, injection molding, a casting mold, or a press. Therefore, in general, the flow channel member is prepared by laminating a plurality of sheets in which a complicated penetration hole that becomes the flow channel is individually formed. In addition, in a case of a heat exchanger in which temperature raising and cooling are repeated, when the cover unit, the side wall unit, and the bottom plate unit are formed of the same material as each other, there is a little concern that separation of the joint portion due to a difference in thermal expansion occurs. Therefore, in a case where the flow channel has a complicate shape and wide range of use age temperature, it is preferable that the ceramic green sheets are laminated and fired to form the ceramic flow channel member.

### Example 2

Next, a relationship between the shape and the joint failure of the gap 4 which communicates with the flow channel 3 and is formed at the joint portion 1d between the cover unit 1a and the side wall unit 1c was confirmed.

The same samples were prepared using the same alumina ceramics used in the Example 1, and the evaluation method about the joint failure is the same as Example 1.

In addition, Sample Nos. 1 and 14 are the same as Example 1. However, in Sample Nos. 2 to 8, the gap 4 has a rectangular shape, in Sample Nos. 11 to 17, the gap 4 has a trapezoidal shape, and in Sample Nos. 21 to 27, the gap 4 has a triangular shape. In addition, shaping was performed by preparing a die that matches with the shape of each of the samples, and the depth 4a and the maximum height 4b of the gap 4 were set as shown in a table.

Results that were obtained are shown in Table 2.

**[Table 2]**

| Sample No. | Gap at joint portion between cover unit and side wall unit of flow channel | | | | Rate of occurrence of joint failure | Evaluation | Cause of joint failure |
|---|---|---|---|---|---|---|---|
| | Present or absent | Shape | Depth | Maximum height | | | |
| | | | (mm) | (mm) | (%) | | |
| 1 | Absent | - | - | - | 8 | Bad | Burr |
| 2 | Present | Rectangular | 0.02 | 0.01 | 2 | Good | Burr |
| 3 | Present | Rectangular | 0.03 | 0.01 | 0 | Very good | - |
| 4 | Present | Rectangular | 0.04 | 0.02 | 0 | Very good | - |
| 5 | Present | Rectangular | 0.08 | 0.06 | 0 | Very good | - |
| 6 | Present | Rectangular | 0.09 | 0.07 | 2 | Good | Deficiency in pressure propagation |
| 7 | Present | Rectangular | 0.03 | 0.03 | 2 | Good | Burr |
| 8 | Present | Rectangular | 0.08 | 0.08 | 2 | Good | Burr |
| 11 | Present | Trapezoidal | 0.02 | 0.01 | 2 | Good | Burr |
| 12 | Present | Trapezoidal | 0.03 | 0.01 | 0 | Very good | - |
| 13 | Present | Trapezoidal | 0.04 | 0.02 | 0 | Very good | - |
| 14 | Present | Trapezoidal | 0.08 | 0.06 | 0 | Very good | - |
| 15 | Present | Trapezoidal | 0.09 | 0.07 | 2 | Good | Deficiency in pressure propagation |
| 16 | Present | Trapezoidal | 0.03 | 0.03 | 2 | Good | Burr |
| 17 | Present | Trapezoidal | 0.08 | 0.08 | 2 | Good | Burr |
| 21 | Present | Triangular | 0.02 | 0.01 | 2 | Good | Burr |
| 22 | Present | Triangular | 0.03 | 0.01 | 0 | Very good | - |
| 23 | Present | Triangular | 0.04 | 0.02 | 0 | Very good | - |
| 24 | Present | Triangular | 0.08 | 0.06 | 0 | Very good | - |
| 25 | Present | Triangular | 0.09 | 0.07 | 2 | Good | Deficiency in pressure propagation |
| 26 | Present | Triangular | 0.03 | 0.03 | 2 | Good | Burr |
| 27 | Present | Triangular | 0.08 | 0.08 | 2 | Good | Burr |

As can be seen from results shown in Table 2, first, in Sample No. 1, a rate of occurrence of the joint failure was 8%, and the evaluation was bad. In addition, non-fired samples that were stored were examined, and as a result of the examination, it was confirmed that a burr, which occurred during shaping the ceramic green sheet by the die 21, was attached to the joint portion of the laminated ceramic green sheets, and the joint of the ceramic green sheets was not performed sufficiently due to the burr.

In Sample Nos. 2, 11, and 21 of this example, the rate of occurrence of the joint failure was 2%, and the evaluation was good. A cause of the joint failure was the burr that occurred during shaping of the ceramic green sheet by the die 21 similarly to Sample No. 1, and the rate of occurrence was small. However, it is assumed that since the depth 4a of the gap 4 is as shallow as 0.02 mm, the burr that occurs at the flow channel side end surface of the ceramic green sheet is interposed at the joint portion during pressing the ceramic green sheet.

In addition, in Sample Nos. 6, 15, and 25 of this example, the rate of occurrence of the joint failure was 2%, and the evaluation was good similarly to Sample No. 2, but the interposition of the burr that becomes the cause of the joint failure was not found. The Prescale, which was interposed so as to examine a pressure propagation state during pressing of the ceramic green sheets after laminating these, was confirmed, and as a result of this confirmation, in the vicinity of a portion at which the depth 4a of the gap 4 was near approximately 0.09 mm when being converted to a dimensional value after being fired, a coloring concentration of a red color was light, and thus it was considered that the joint failure was caused by a deficiency of pressure propagation during the pressing.

In addition, in Sample Nos. 7, 8, 16, 17, 26, and 27, the lengths of the depth 4a and the maximum height 4b of the gap 4 were the same as each other, but the rate of occurrence of the joint failure was 2% in each case, and the evaluation was good. The joint failure was caused because the maximum height 4b and the depth 4a were the same as each other, and thus a part of the burr entered the joint portion.

In addition, in Sample Nos. 3 to 5, 12 to 14, and 22 to 24 in which the depth 4a of the gap 4 was 0.03 mm, 0.04 mm, and 0.08 mm, respectively, and was longer than the maximum height 4b, the rate of occurrence of the joint failure was 0% and the evaluation was very good in each case. In addition, the joint portion of the non-fired samples was confirmed, but occurrence of the joint failure due to trapping of the burr in the flow channel side end surface of the ceramic green sheet to the joint portion of the ceramic green sheet was not found.

From the above-described results, in a case where the flow channel member 12 was formed by laminating the ceramic green sheets and the flow channel was formed inside the flow channel member 12, it can be seen that when the gap 4 that opens toward the flow channel 3 side is located at the joint portion 1d of the laminated ceramic green sheets in the side surface of flow channel, the occurrence of joint failure may be suppressed.

In addition, it is revealed that the shape of the gap 4 may be any one of rectangular shape, a trapezoidal shape, and a triangular shape that open toward the flow channel 3 side.

As the shape of the gap 4, the rectangular shape or the trapezoidal shape is selected when the burr, which occurs at the end face of the penetration hole that becomes the flow channel 3, is intended to be permitted in the gap 4 of the ceramic green sheets in a manufacturing process, and the triangular shape is selected when the size of the burr is intended to be suppressed. A processing method may be suitably selected.

In addition, when the depth 4a of the gap 4 is 0.03 to 0.08 mm and is longer than the length of the maximum height 4b, occurrence of the joint failure due to interposition of the burr at the joint portion during laminating and pressing the ceramic green sheets, and occurrence of the joint failure due to the deficiency of the propagation of the pressing force may be further suppressed.

### Example 3

Next, when a content of aluminum oxide was increased or decreased, an effect thereof on the joint failure of the joint portion 1d between the cover unit 1a and the side wall unit 1c was examined.

Here, Sample Nos. 9 and 10 shown in Table 3 were prepared, in which the respective dimensions of the flow channel member 12 shown in Fig. 7 were the same as Sample No. 4 used in Example 2, but the content of the aluminum oxide was changed to 94.0% by mass and 97.0% by mass, respectively, and the remainder includes silicon oxide, calcium oxide, and magnesium oxide.

50 flow channel members 12 of respective samples were prepared by the same method as Example 1, and confirmation of the joint failure was performed by the ultrasonic testing, and the evaluation was performed by the same method as Example 1.

Results that were obtained are shown in Table 3.

**[Table 3]**

| Sample No. | Compositional content of flow channel member | | | | Rate of occurrence of joint failure | Evaluation | Cause of joint failure |
|---|---|---|---|---|---|---|---|
| | Al₂O₃ | SiO₂ | CaO | MgO | | | |
| | (% by mass) | (% by mass) | (% by mass) | (% by mass) | (%) | | |
| 9 | 94.0 | 3.0 | 0.6 | 2.4 | 0 | Very good | - |
| 10 | 97.0 | 1.0 | 0.4 | 1.6 | 0 | Very good | - |

As can be seen from the results shown in Table 3, in this example, in all of Sample No. 9 in which the content of aluminum oxide was 94.0% by mass and Sample No. 10 in which the content of aluminum oxide was 97.0% by mass, the rate of occurrence of the joint failure of the joint portion 1d was 0%, and the evaluation was very good.

Here, the flow channel member 12 is a structure having exterior dimensions in which the length "L" is 200 mm, the width "D" is 12 mm, and the height "H" is 4.5 mm, but when the content of the aluminum oxide is set to 94.0 to 97.0% by mass, and the remainder includes silicon oxide, calcium oxide, and magnesium oxide, it can be said that occurrence of a problem in a sintering property is suppressed from the viewpoint that joint is obtained without problem at each joint portion 1d between the cover unit 1a and the side wall unit 1c inside the flow channel member 12 even when a firing temperature is 1600°C as it is. When an appropriate sintering additive is contained, a sintering property may be increased, and thus it is not necessary to raise the sintering temperature, and a sintering cost may be reduced.

As described above, in the flow channel member 12 of this examples, there is a little concern that the joint failure of the side wall unit occurs, and even when a fluid is made to flow at a high pressure and the flow channel member 12 is used for a cooling or warming purpose, or the like, occurrence of interlayer separation may be suppressed. In addition, a flow channel member with a relative low cost may be provided.

### Reference Signs List

- 1, 11, 12, 13, 14, 15:: Flow channel member
- 1a:: Cover unit
- 1b:: Bottom plate unit
- 1c:: Side wall unit
- 1d:: Joint portion
- 1e:: Chamfer
- 1f:: Burr
- 1g:: End surface
- 3:: Flow channel
- 4:: Gap
- 4a:: Depth of gap
- 4b:: Maximum height of gap
- 5:: Metallic plate
- 6:: Electronic component
- 7, 8:: Processed ceramic green sheet
- 7b', 8b':: End surface
- 7c', 8c':: Chamfer
- 20:: Heat exchanger
- 30:: Electronic component device

## Claims

1. A flow channel member adapted for use in a heat exchanger of an electronic component device, comprising:
a cover unit (1a);
a bottom plate unit (1b); and
a side wall unit (1c) comprising a plate-like body having a hole which forms a flow channel (3) through which a fluid can flow and which is provided inside the flow channel member,
**characterized in that**
a first gap (4) which communicates with the flow channel (3) is provided at a joint portion (1d) between the cover unit (1a) and the plate-like body,
the first gap (4) is formed by a chamfered portion which is provided between an end surface (lg) of the plate-like body that faces the flow channel and an upper surface of the plate-like body that faces the cover unit (1a),
the side wall unit (1c) is a laminated body composed of a plurality of plate-like bodies having a hole which forms the flow channel (3),
a second gap (4) which communicates with the flow channel (3) is located at a joint portion (1d) between two adjacent plate-like bodies of the plurality of plate-like bodies constituting the laminated body, and
the first and second gaps (4) are formed by chamfered portions which are provided on a respective one of the plurality of plate-like bodies between an end surface (1g) of the respective one of the plurality of plate-like bodies that faces the flow channel and an upper surface of the respective one of the plurality of plate-like bodies.

2. The flow channel member according to claim 1, wherein when seen in a cross-sectional view in a direction orthogonal to a direction in which the fluid flows, the first and second gaps (4) have a trapezoidal or triangular shape.

3. The flow channel member according to claim 1 or 2, wherein when seen in a cross-sectional view in a direction orthogonal to a direction in which the fluid flows, a height of the first and second gaps (4) in a vertical direction becomes lower along a direction from the flow channel (3) side to the side wall unit (1c) side.

4. The flow channel member according to any one of claim 1 to 3, wherein when seen in a cross-sectional view in a direction orthogonal to a direction in which the fluid flows, a relationship a > b is satisfied, wherein "a" denotes a depth in a direction in which the first and second gaps (4) extend from the flow channel (3) side to the side wall unit (1c) side, and "b" denotes a maximum height in a direction in which the first and second gaps (4) vertically open.

5. The flow channel member according to claim 4, wherein the depth is 0.03 to 0.08 mm.

6. A heat exchanger, comprising:
the flow channel member according to any one of claim 1 to 5; and
a metallic plate (5) disposed on an outer surface of the cover unit (1a) of the flow channel member.

7. An electronic component device, comprising:
the heat exchanger according to claim 6; and
an electronic component (6) mounted on the metallic plate (5) of the heat exchanger (20).

## Patentansprüche

1. Strömungskanalelement, das zur Verwendung in einem Wärmetauscher einer elektronischen Bauelementvorrichtung geeignet ist, aufweisend:
eine Abdeckeinheit (1a),
eine Bodenplatteneinheit (1b) und
eine Seitenwandeinheit (1c), die einen plattenartigen Körper mit einem Loch aufweist, das einen Strömungskanal (3) bildet, durch den ein Fluid strömen kann und der im Inneren des Strömungskanalelements vorgesehen ist,
**dadurch gekennzeichnet, dass**
ein erster Spalt (4), der mit dem Strömungskanal (3) kommuniziert, an einem Verbindungsabschnitt (1d) zwischen der Abdeckeinheit (1a) und dem plattenartigen Körper vorgesehen ist,
der erste Spalt (4) durch einen abgeschrägten Abschnitt ausgebildet ist, der zwischen einer Endfläche (1g) des plattenartigen Körpers, die dem Strömungskanal zugewandt ist, und einer oberen Fläche des plattenartigen Körpers, die der Abdeckeinheit (1a) zugewandt ist, vorgesehen ist,
die Seitenwandeinheit (1c) ein laminierter Körper ist, der aus einer Mehrzahl von plattenartigen Körpern mit einem Loch zusammengesetzt ist, das den Strömungskanal (3) bildet,
ein zweiter Spalt (4), der mit dem Strömungskanal (3) kommuniziert, an einem Verbindungsabschnitt (1d) zwischen zwei benachbarten plattenartigen Körpern der Mehrzahl von plattenartigen Körpern angeordnet ist, die den laminierten Körper bilden, und
der erste und der zweite Spalt (4) durch abgeschrägte Abschnitte gebildet sind, die auf einem jeweiligen der Mehrzahl von plattenartigen Körpern zwischen einer Endfläche (1g) des jeweiligen der Mehrzahl von plattenartigen Körpern, die dem Strömungskanal zugewandt ist, und einer oberen Fläche des jeweiligen der Mehrzahl von plattenartigen Körpern vorgesehen sind.

2. Strömungskanalelement gemäß Anspruch 1, wobei bei Betrachtung in einer Querschnittsansicht in einer Richtung orthogonal zu einer Richtung, in der das Fluid strömt, der erste und der zweite Spalt (4) eine trapezförmige oder dreieckige Form haben.

3. Strömungskanalelement gemäß Anspruch 1 oder 2, wobei bei Betrachtung in einer Querschnittsansicht in einer Richtung orthogonal zu einer Richtung, in der das Fluid strömt, eine Höhe des ersten und des zweiten Spalts (4) in einer vertikalen Richtung entlang einer Richtung von der Strömungskanal- (3) Seite zu der Seitenwandeinheit- (1c) Seite geringer wird.

4. Strömungskanalelement gemäß irgendeinem der Ansprüche 1 bis 3, wobei bei Betrachtung in einer Querschnittsansicht in einer Richtung orthogonal zu einer Richtung, in der das Fluid strömt, ein Verhältnis a > b erfüllt ist, wobei "a" eine Tiefe in einer Richtung bezeichnet, in der sich der erste und der zweite Spalt (4) von der Strömungskanal- (3) Seite zu der Seitenwandeinheit- (1c) Seite erstrecken, und "b" eine maximale Höhe in einer Richtung bezeichnet, in der sich der erste und der zweite Spalt (4) vertikal öffnen.

5. Strömungskanalelement gemäß Anspruch 4, wobei die Tiefe 0,03 bis 0,08 mm beträgt.

6. Wärmetauscher, aufweisend:
das Strömungskanalelement gemäß irgendeinem der Ansprüche 1 bis 5 und
eine Metallplatte (5), die auf einer Außenfläche der Abdeckeinheit (1a) des Strömungskanalelements angeordnet ist.

7. Elektronische Bauelementvorrichtung, aufweisend:
den Wärmetauscher gemäß Anspruch 6 und
ein elektronisches Bauelement (6), das auf der Metallplatte des Wärmetauschers (20) montiert ist.

## Revendications

1. Un élément de canal d'écoulement adapté pour être utilisé dans un échangeur de chaleur d'un dispositif de composant électronique, comprenant :
une unité de couverture (la) ;
une unité de plaque inférieure (1b) ; et
une unité de paroi latérale (1c) comprenant un corps en forme de plaque ayant un trou qui forme un canal d'écoulement (3) à travers lequel un fluide peut s'écouler et qui est prévu à l'intérieur de l'élément de canal d'écoulement,
**caractérisé en ce que**
un premier espace (4) qui communique avec le canal d'écoulement (3) est prévu au niveau d'une partie de jonction (1d) entre l'unité de couverture (la) et le corps en forme de plaque,
le premier espace (4) est formé par une partie chanfreinée qui est prévue entre une surface d'extrémité (1g) du corps en forme de plaque qui fait face au canal d'écoulement et une surface supérieure du corps en forme de plaque qui fait face à l'unité de couverture (la),
l'unité de paroi latérale (1c) est un corps laminé composé d'une pluralité de corps en forme de plaque ayant un trou qui forme le canal d'écoulement (3),
un deuxième espace (4) qui communique avec le canal d'écoulement (3) est situé au niveau d'une partie de jonction (1d) entre deux corps en forme de plaque adjacents de la pluralité de corps en forme de plaque constituant le corps laminé, et
les premier et deuxième espaces (4) sont formés par des parties chanfreinées qui sont prévues sur un corps respectif de la pluralité de corps en forme de plaque entre une surface d'extrémité (1g) du corps respectif de la pluralité de corps en forme de plaque qui fait face au canal d'écoulement et une surface supérieure du corps respectif de la pluralité de corps en forme de plaque.

2. L'élément de canal d'écoulement selon la revendication 1, dans lequel, lors d'une vue en coupe transversale dans une direction orthogonale à une direction dans laquelle le fluide s'écoule, les premier et deuxième espaces (4) ont une forme trapézoïdale ou triangulaire.

3. L'élément de canal d'écoulement selon la revendication 1 ou 2, dans lequel, lors d'une vue en coupe transversale dans une direction orthogonale à une direction dans laquelle le fluide s'écoule, une hauteur des premier et deuxième espaces (4) dans une direction verticale devient plus basse le long d'une direction allant du côté de canal d'écoulement (3) au côté d'unité de paroi latérale (1c).

4. L'élément de canal d'écoulement selon l'une quelconque des revendications 1 à 3, dans lequel, lors d'une vue en coupe transversale dans une direction orthogonale à une direction dans laquelle le fluide s'écoule, une relation a > b est satisfaite, où « a » désigne une profondeur dans une direction dans laquelle les premier et deuxième espaces (4) s'étendent du côté de canal d'écoulement (3) au côté d'unité de paroi latérale (1c), et « b » désigne une hauteur maximale dans une direction dans laquelle les premier et deuxième espaces (4) s'ouvrent verticalement.

5. L'élément de canal d'écoulement selon la revendication 4, dans lequel la profondeur est de 0,03 à 0,08 mm.

6. Un échangeur de chaleur, comprenant :
l'élément de canal d'écoulement selon l'une quelconque des revendications 1 à 5 ; et
une plaque métallique (5) disposée sur une surface extérieure de l'unité de couverture (la) de l'élément de canal d'écoulement.

7. Un dispositif de composant électronique, comprenant :
l'échangeur de chaleur selon la revendication 6 ; et
un composant électronique (6) monté sur la plaque métallique (5) de l'échangeur de chaleur (20).
